(19) 

(11) **EP 4 793 618 A1**

(12) **EUROPEAN PATENT APPLICATION**
published in accordance with Art. 153(4) EPC

(43) Date of publication:
**19.08.2026 Bulletin 2026/34**

(21) Application number: **24877292.3**

(22) Date of filing: **11.10.2024**

(51) International Patent Classification (IPC):
***G01M 13/04*** *(2019.01)* ***G01R 31/00*** *(2006.01)*

(52) Cooperative Patent Classification (CPC):
**G01M 13/04; G01R 31/00**

(86) International application number:
**PCT/JP2024/036484**

(87) International publication number:
**WO 2025/079698 (17.04.2025 Gazette 2025/16)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **13.10.2023 JP 2023177664**

(71) Applicant: **NSK Ltd.**
**Tokyo 141-8560 (JP)**

(72) Inventors:
- **KOSUGI Daichi**
**Fujisawa-shi, Kanagawa 251-8501 (JP)**
- **IWASE Shunsuke**
**Fujisawa-shi, Kanagawa 251-8501 (JP)**
- **AIKAWA Fumiaki**
**Fujisawa-shi, Kanagawa 251-8501 (JP)**
- **MOMOZONO Satoshi**
**Fujisawa-shi, Kanagawa 251-8501 (JP)**
- **MARUYAMA Taisuke**
**Fujisawa-shi, Kanagawa 251-8501 (JP)**

(74) Representative: **Grünecker Patent- und Rechtsanwälte**
**PartG mbB**
**Leopoldstraße 4**
**80802 München (DE)**

# (54) METHOD FOR MEASURING REVOLUTION PERIOD OF ROLLING ELEMENT OF ROLLING BEARING, ROLLING BEARING STATE DETECTING METHOD, MEASURING DEVICE, STATE MONITORING DEVICE, AND PROGRAM

(57) Provided is a measuring device for measuring the revolution period of a rolling element of a rolling bearing, the measuring device including: an acquiring means for acquiring waveform data of a current and a voltage applied to the rolling bearing; a calculating means for calculating an instantaneous amplitude and an instantaneous phase from the waveform data using a Hilbert transform; a deriving means for deriving an impedance using the waveform data, the instantaneous amplitude, and the instantaneous phase; and an identifying means for identifying the period of the impedance using an autocorrelation function and identifying the period as the revolution period of the rolling element of the rolling bearing.

EP 4 793 618 A1

*FIG. 7A*

V [V]
1
0
-1
0.001
0.000
-0.001
I [A]

*FIG. 7B*

|Z| [Ω]
2000
1500
1000
500
0

*FIG. 7C*

θ [°]
0
-50
-100
0.0
0.1
0.2
0.3
0.4
0.5
time

*FIG. 7D*

$T_{theory}$
ACF [-]
1.0
0.8
0.6
0.4
0.2
0.0
0.0
0.1
0.2
0.3
0.4
0.5
time [s]

## Description

### TECHNICAL FIELD

The present invention relates to a method of measuring a revolution period of a rolling element of a rolling bearing, a state detection method for a rolling bearing, a measurement device, a state detection device, and a program.

### BACKGROUND ART

In the related art, in a rolling bearing, an abnormality such as burn-in may occur as a result of a rotation operation. The burn-in affects an operation of the rolling bearing, and a progress of this state causes a stop or failure of the device. For an appropriate operation of the rolling bearing, it is effective to capture and detect a sign of occurrence of the burn-in. One of causes of the burn-in is occurrence of revolution sliding around a rolling element in the rolling bearing. As a method in the related art, for example, a method of detecting revolution sliding by focusing on a strain gauge, vibration, ultrasonic waves, an overcurrent, and the like is known.

For example, Patent Literature 1 discloses a method of monitoring a state of a rolling bearing by detecting the number of revolutions by ultrasonic waves and monitoring revolution sliding based on the number of revolutions. Patent Literature 2 discloses a method of detecting vibration of a rolling bearing and performing abnormality diagnosis of the rolling bearing based on a peak value of frequency spectrum data based on vibration information.

### CITATION LIST

### PATENT LITERATURE

Patent Literature 1: JP2021-32769A
Patent Literature 2: JP7027782B

### SUMMARY OF INVENTION

### TECHNICAL PROBLEM

The strain gauge, an ultrasonic sensor, and the like used in the related art described above have certain restrictions for attachment. In addition, in a configuration in which high-speed rotation is performed in a rolling bearing, a higher sampling period of a detection value is required in order to perform more accurate measurement. Therefore, for example, in order to monitor a state of the rolling bearing, a method of accurately measuring a revolution period of a rolling element in the rolling bearing with a simple configuration is required.

In view of the above problems, an object of the present invention is to provide a method of measuring a revolution period of a rolling element in a rolling bearing that rotates at high speed with a simple configuration.

### SOLUTION TO PROBLEM

In order to solve the above problem, the present invention has the following configuration. That is, a measurement device for measuring a revolution period of a rolling element of a rolling bearing includes: an acquisition unit configured to acquire waveform data of a current and a voltage applied to the rolling bearing; a calculation unit configured to calculate an instantaneous amplitude and an instantaneous phase based on the waveform data by using Hilbert transformation; a derivation unit configured to derive an impedance by using the waveform data, the instantaneous amplitude, and the instantaneous phase; and a specification unit configured to specify a period of the impedance by using an autocorrelation function and specify the period of the impedance as the revolution period of the rolling element of the rolling bearing.

In addition, another aspect of the present invention has the following configuration. That is, a state detection device for a rolling bearing, includes: an acquisition unit configured to acquire waveform data of a current and a voltage applied to the rolling bearing; a calculation unit configured to calculate an instantaneous amplitude and an instantaneous phase based on the waveform data by using Hilbert transformation; a derivation unit configured to derive an impedance by using the waveform data, the instantaneous amplitude, and the instantaneous phase; a specification unit configured to specify a period of the impedance by using an autocorrelation function and specify the period of the impedance as a revolution period of a rolling element of the rolling bearing; a detection unit configured to detect revolution sliding in the

rolling bearing in response to the revolution period falling below a predetermined threshold value; and a notification unit configured to output a notification of a state of the rolling bearing based on a detection result obtained by the detection unit.

In addition, another aspect of the present invention has the following configuration. That is, a measurement method for measuring a revolution period of a rolling element of a rolling bearing, the measurement method includes: an acquisition step of acquiring waveform data of a current and a voltage applied to the rolling bearing; a calculation step of calculating an instantaneous amplitude and an instantaneous phase based on the waveform data by using Hilbert transformation; a derivation step of deriving an impedance by using the waveform data, the instantaneous amplitude, and the instantaneous phase; and a specification step of specifying a period of the impedance by using an autocorrelation function and specifying the period of the impedance as the revolution period of the rolling element of the rolling bearing.

In addition, another aspect of the present invention has the following configuration. That is, a state detection method for a rolling bearing, includes: an acquisition step of acquiring waveform data of a current and a voltage applied to the rolling bearing; a calculation step of calculating an instantaneous amplitude and an instantaneous phase based on the waveform data by using Hilbert transformation; a derivation step of deriving an impedance by using the waveform data, the instantaneous amplitude, and the instantaneous phase; a specification step of specifying a period of the impedance by using an autocorrelation function and specifying the period of the impedance as a revolution period of a rolling element of the rolling bearing; a detection step of detecting revolution sliding in the rolling bearing in response to the revolution period falling below a predetermined threshold value; and a notification step of outputting a notification of a state of the rolling bearing based on a detection result obtained by the detection step.

In addition, another aspect of the present invention has the following configuration. That is, a program causes a computer to execute procedures including: an acquisition step of acquiring waveform data of a current and a voltage applied to a rolling bearing; a calculation step of calculating an instantaneous amplitude and an instantaneous phase based on the waveform data by using Hilbert transformation; a derivation step of deriving an impedance by using the waveform data, the instantaneous amplitude, and the instantaneous phase; and a specification step of specifying a period of the impedance by using an autocorrelation function and specifying the period of the impedance as a revolution period of a rolling element of the rolling bearing.

In addition, another aspect of the present invention has the following configuration. That is, a program causes a computer to execute procedures including: an acquisition step of acquiring waveform data of a current and a voltage applied to a rolling bearing; a calculation step of calculating an instantaneous amplitude and an instantaneous phase based on the waveform data by using Hilbert transformation; a derivation step of deriving an impedance by using the waveform data, the instantaneous amplitude, and the instantaneous phase; a specification step of specifying a period of the impedance by using an autocorrelation function and specifying the period of the impedance as a revolution period of a rolling element of the rolling bearing; a detection step of detecting revolution sliding in the rolling bearing in response to the revolution period falling below a predetermined threshold value; and a notification step of outputting a notification of a state of the rolling bearing based on a detection result obtained by the detection step.

## ADVANTAGEOUS EFFECTS OF INVENTION

According to the present invention, it is possible to measure the revolution period of the rolling element in the rolling bearing that rotates at high speed with a simple configuration.

## BRIEF DESCRIPTION OF DRAWINGS

Fig. 1 is a schematic diagram illustrating a configuration example of a measurement system according to an embodiment of the present invention.

Figs. 2A and 2B are diagrams illustrating a change in a load zone in a rolling bearing according to the embodiment of the present invention.

Figs. 3A and 3B are graphs illustrating an example of raw waveform data used in the embodiment of the present invention.

Figs. 4A to 4C are graphs illustrating an example of waveform conversion used in the embodiment of the present invention.

Figs. 5A to 5C are graphs illustrating an example of waveform conversion used in the embodiment of the present invention.

Figs. 6A and 6B are diagrams illustrating an autocorrelation function used in the embodiment of the present invention.

Figs. 7A to 7D are graphs illustrating an example of test results according to the embodiment of the present invention.

Figs. 8A to 8D are graphs illustrating an example of test results according to the embodiment of the present invention.

Figs. 9A to 9D are graphs illustrating an example of test results according to the embodiment of the present invention.

Fig. 10 is a graph illustrating a relationship between a radial load and a contact area according to the embodiment of the present invention.

Figs. 11A to 11C are graphs illustrating a relationship between a load direction and periodicity according to the embodiment of the present invention.

Fig. 12 is a flowchart of state detection processing according to the embodiment of the present invention.

DESCRIPTION OF EMBODIMENTS

Hereinafter, embodiments of the present invention will be described with reference to the drawings. The embodiments described below are embodiments for explaining the present invention, and are not intended to be interpreted to limit the present invention, and all the configurations described in the embodiments are not necessarily essential configurations for solving the problems of the present invention. In the drawings, the same components are denoted by the same reference numerals, thereby showing a correspondence relationship therebetween.

<First Embodiment>

Hereinafter, a first embodiment of the present invention will be described. Examples of a type of a rolling bearing to which a method of measuring a revolution period of a rolling element of the rolling bearing and a state detection method for the rolling bearing according to the present invention are applicable include a deep groove ball bearing, an angular contact ball bearing, a tapered roller bearing, a cylindrical roller bearing, and a self-aligning roller bearing. However, the present invention is not limited thereto, and is also applicable to other rotating devices such as bearings and gear devices as long as waveform data of a current and a voltage described later can be acquired.

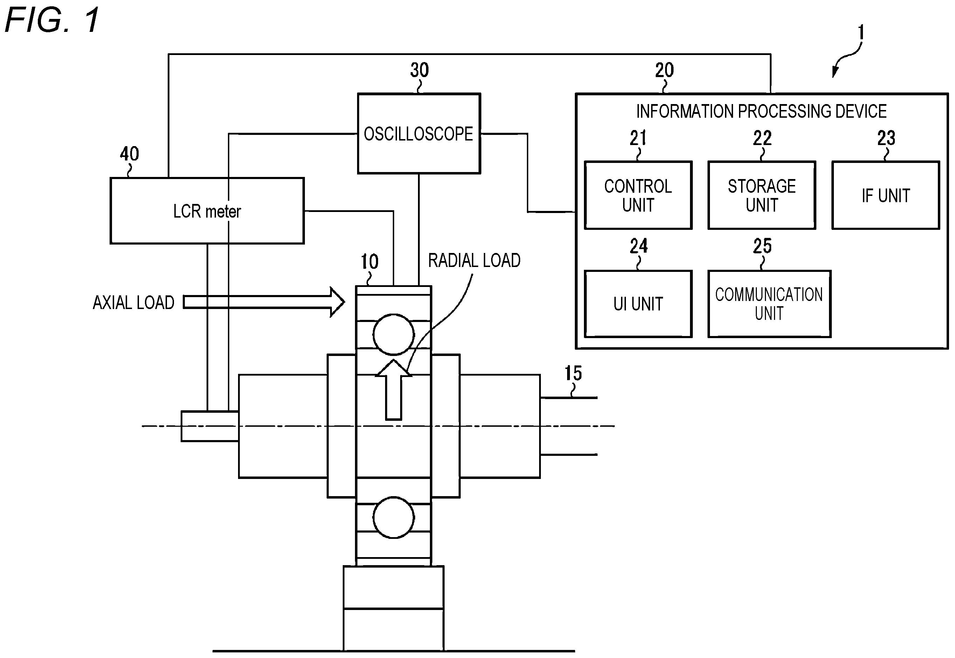

Fig. 1 is a diagram illustrating a configuration example of a measurement system 1 to which a measurement method and a state detection method according to the present embodiment can be applied. The measurement system 1 includes a rolling bearing 10 to be measured, an information processing device 20, and an oscilloscope 30. In addition, although not an essential element in the method according to the present embodiment, the measurement system 1 in Fig. 1 includes an LCR meter 40 used in a test described later.

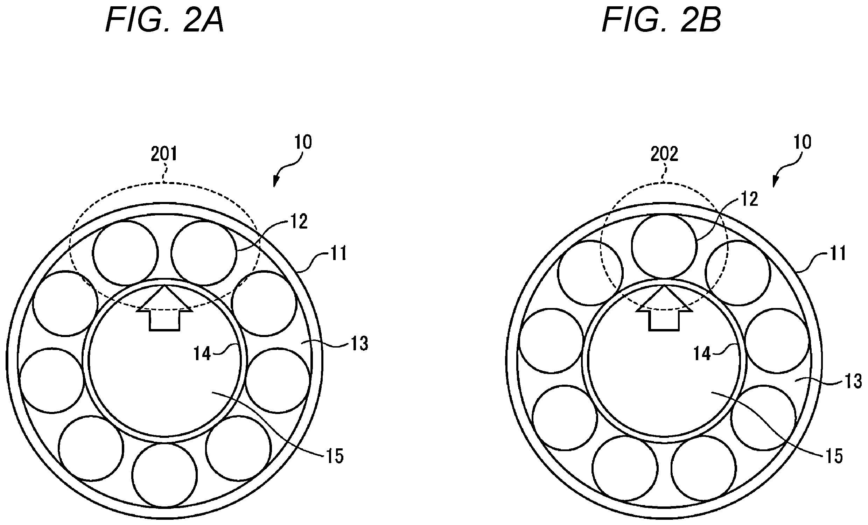

The rolling bearing 10 is coupled to a rotation shaft 15 and is rotatable. Here, an inner ring is a rotation ring, and an outer ring is a fixed ring. A configuration example of the rolling bearing 10 will be described with reference to Figs. 2A and 2B. The rotation shaft 15 is connected to a motor (not illustrated) and rotates the rolling bearing 10 while applying a load (radial load, axial load) in a predetermined direction to the rolling bearing 10. In the present embodiment, rotation control of the motor (not illustrated) and control of the load applied to the rolling bearing 10 are performed by the information processing device 20, but control related to a rotation operation of the rolling bearing 10 may be performed using a separate control device (not illustrated).

The information processing device 20 includes a control unit 21, a storage unit 22, an interface (IF) unit 23, a user interface (UI) unit 24, and a communication unit 25. The information processing device 20 may be implemented as, for example, a general-purpose information processing device such as a personal computer (PC) or may be implemented as a dedicated device.

The control unit 21 of the information processing device 20 may include a central processing unit (CPU), a micro processing unit (MPU), a digital single processor (DSP), and a dedicated circuit. The storage unit 22 includes volatile and nonvolatile storage media such as a hard disk drive (HDD), a read only memory (ROM), and a random access memory (RAM), and may input and output various kinds of information in response to an instruction from the control unit 21.

The IF unit 23 is an interface for connecting to an external device, and in the present embodiment, is able to transmit and receive data to and from the oscilloscope 30 and the LCR meter 40. The UI unit 24 receives an operation from a user and displays various kinds of information such as a measurement result. The UI unit 24 includes a speaker, a light, or a display device such as a liquid crystal display, and performs output to the user in response to an instruction from the control unit 21. An output method by the UI unit 24 is not particularly limited, and may be, for example, visual output by screen output or auditory output by voice. The communication unit 25 is a network interface for communicating with an external device.

The oscilloscope 30 is electrically connected to the rolling bearing 10 and the rotation shaft 15, and measures a current and a voltage applied thereto. In the present embodiment, the oscilloscope 30 performs measurement by using an AC power supply and regarding the rolling bearing 10 as an electric circuit. The oscilloscope 30 provides a measurement result to the information processing device 20 as appropriate. The LCR meter 40 is electrically connected to the rolling bearing 10 and the rotation shaft 15, and applies an AC power supply to the rolling bearing 10 and the rotation shaft 15 to measure an impedance and phase. The LCR meter 40 provides a measurement result to the information processing device 20 as appropriate. The measurement results obtained by the oscilloscope 30 and the LCR meter 40 are managed by the information processing device 20 in association with a measurement timing (time information and the like).

(Load Zone of Rolling Bearing)

Figs. 2A and 2B are schematic diagrams illustrating a change in rolling elements in a load zone of the rolling bearing 10 during a rotation operation. The rolling bearing 10 includes an outer ring 11, a plurality of rolling elements 12 such as balls, a cage 13 holding the rolling elements 12, and an inner ring 14. A lubricant (not illustrated) is filled around the rolling elements 12 to lubricate between members. The outer ring 11 is a fixed ring and is fixed to a housing (not illustrated). The inner ring 14 is a rotation ring, is coupled to the rotation shaft 15, and is rotatable integrally with the rotation shaft 15. A drive force from a motor (not illustrated) is transmitted to the rotation shaft 15, and the rotation shaft 15 performs a rotation operation. Here, as an example, nine ball rolling elements 12 are illustrated, but the present invention is not limited thereto.

A load in a predetermined direction is applied to the rolling bearing 10 via the rotation shaft 15. In the example in Figs. 2A and 2B, a radial load applied to the rolling bearing 10 is indicated by an arrow. During a rotation operation of the rolling bearing 10, a contact state between the rolling elements 12 and the outer ring 11 and the inner ring 14 and the number of the rolling elements 12 in the load zone change according to positions of the plurality of rolling elements 12 and a load direction. Fig. 2A illustrates a state in which two (that is, an even number of) rolling elements 12 are in a load zone 201 of the radial load. Fig. 2B illustrates a state in which one (that is, an odd number) rolling element 12 is in a load zone 202 of the radial load.

The state illustrated in Figs. 2A and 2B is periodically repeated by a rotation operation of the rolling bearing 10. By capturing this periodicity, a revolution period of the rolling element 12 can be specified. In the present embodiment, the revolution period of the rolling element 12 is captured based on a current and a voltage measured by the oscilloscope 30.

[Sign of Burn-in]

Here, a relationship between the revolution period of the rolling element 12 associated with the rotation operation of the rolling bearing 10 and the sign of burn-in in the rolling bearing 10 will be described. A frequency of the revolution period of the rolling element 12, that is, a period in which the rolling element 12 passes through the load zone has a certain correlation with the sign of burn-in.

For example, it is assumed that a timing at which the rotation operation of the rolling bearing 10 is started is t0, and the rotation operation is continuously performed. Then, it is assumed that burn-in occurs in the rolling bearing 10 at timing t2 when a certain time has elapsed. In this case, for example, when revolution sliding occurs in the rolling bearing 10, it is known that a decrease in frequency (downward peak value) occurs at timing t1 (< t2) before timing t2. Such an event related to a relationship between damage in the rolling bearing and a measured value is also disclosed in JP2006-17291A by the present applicant. That is, by focusing on a decrease in frequency, the revolution sliding occurring before the burn-in can be captured as a sign of the occurrence of the burn-in in the rolling bearing 10. In the present embodiment, when a frequency of the revolution period of the rolling element 12 falls below a predetermined threshold value, that is, when it is detected that the revolution sliding has occurred, it is treated as a sign of burn-in. In the present embodiment, based on the frequency of the revolution period of the rolling element, an example is shown in which the revolution sliding is treated as a sign of burn-in when the revolution sliding is detected once, but the present invention is not limited thereto. For example, when revolution sliding is detected a plurality of times within a predetermined period, it may be specified as a sign of burn-in.

[Waveform Data]

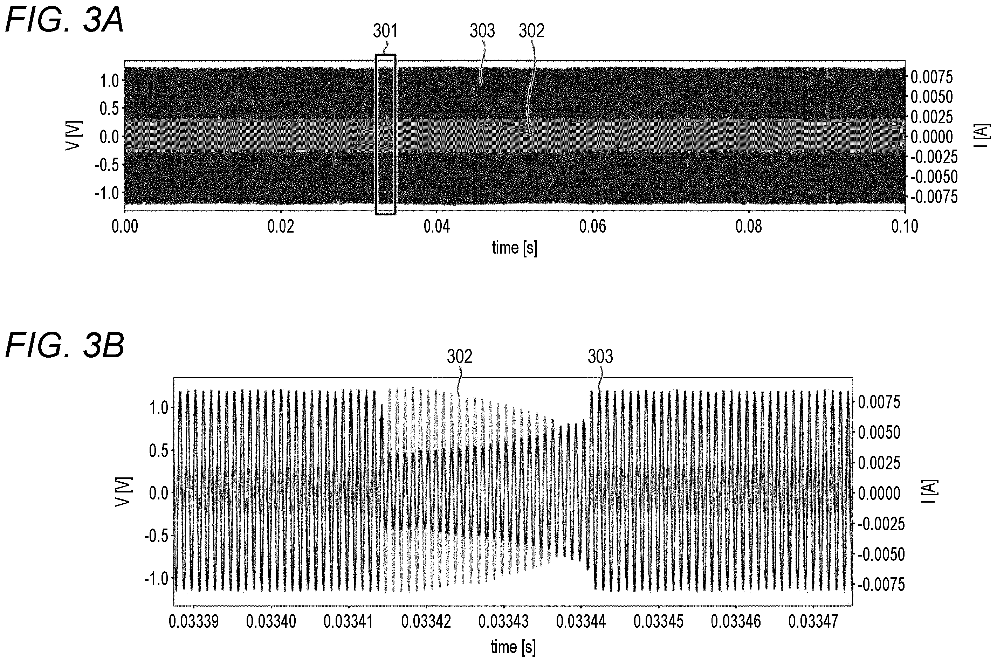

Figs. 3A and 3B illustrate raw waveform data of a signal detected from the rolling bearing 10 by the oscilloscope 30 according to the present embodiment. In Figs. 3A and 3B, a horizontal axis represents time [s], a left vertical axis represents voltage [V], and a right vertical axis represents current [A]. Fig. 3B is an enlarged view of a region 301 illustrated in Fig. 3A. In Figs. 3A and 3B, a waveform 302 indicates a current value, and a waveform 303 indicates a voltage value.

As an example, a sampling frequency is 50 [MS/s] and an AC frequency is 1 MHz. A finite impulse response (FIR) filter is applied to the raw waveform data.

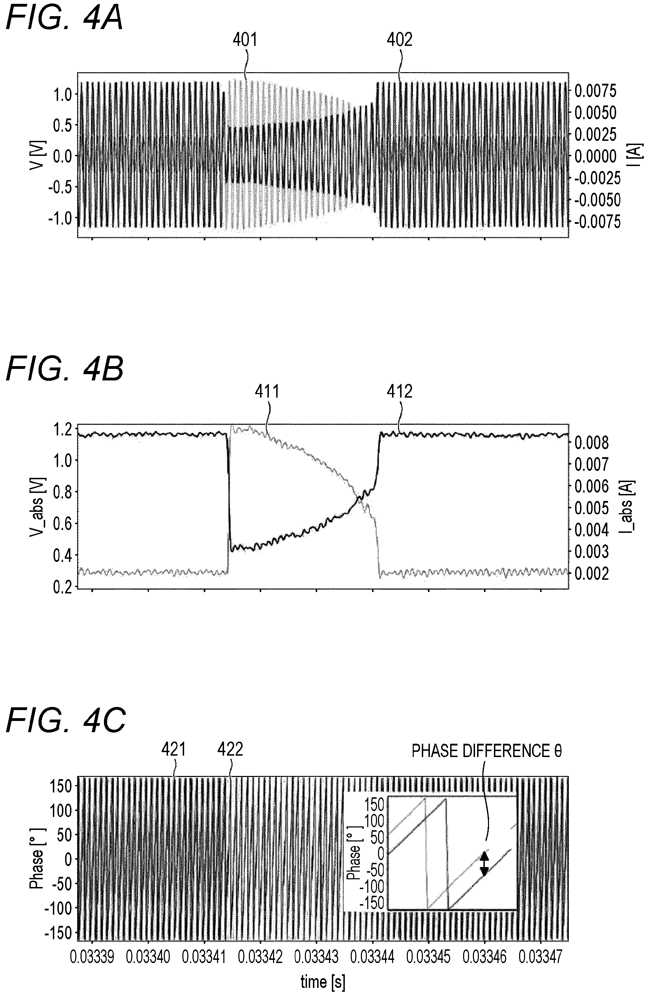

Figs. 4A to 4C illustrates an example in which Hilbert transformation is performed on waveform data of a current and a voltage. A horizontal axis in Figs. 4A to 4C represents time [s], which corresponds to each other. In Fig. 4A, a waveform 401 indicates a current value, and a waveform 402 indicates a voltage value. By the Hilbert transformation, a waveform is captured as a complex number, and an instantaneous amplitude and an instantaneous phase are acquired as instantaneous information regarding a change in the waveform. Since the Hilbert transformation is a known method, detailed description thereof will be omitted.

In the Hilbert transformation, instantaneous amplitude $A(t)$ and instantaneous phase $\theta(t)$ are acquired using the following formulas (1) to (3).

[Math. 1]

$$x(t) = A(t)\cos(\theta(t)) + jA(t)\sin(\theta(t)) \quad \cdots (1)$$

$$A(t) = \sqrt{Re^2 + Im^2} \quad \cdots (2)$$

$$\theta(t) = \tan^{-1}\frac{Im}{Re} \quad \cdots (3)$$

t: time
A(t): instantaneous amplitude (envelope) at time t
$\theta$(t): instantaneous phase at time t
Re: real number
Im: complex number

**[0032]** Fig. 4A illustrates values of a current and a voltage measured by the oscilloscope 30. A left vertical axis represents voltage [V], and a right vertical axis represents current [A]. Fig. 4B illustrates the instantaneous amplitude A(t) obtained based on waveform data in Fig. 4A, in which a left vertical axis in Fig. 4B illustrates the voltage [V] and a right vertical axis illustrates the current [A]. A waveform 411 indicates a current value, and a waveform 412 indicates a voltage. Fig. 4C illustrates the instantaneous phase $\theta$(t) obtained based on the waveform data in Fig. 4B, and a vertical axis illustrates phase [°]. Waveforms 421 and 422 indicate phases of the current and the voltage. At this time, a phase difference between the current and the voltage is indicated by $\theta$.

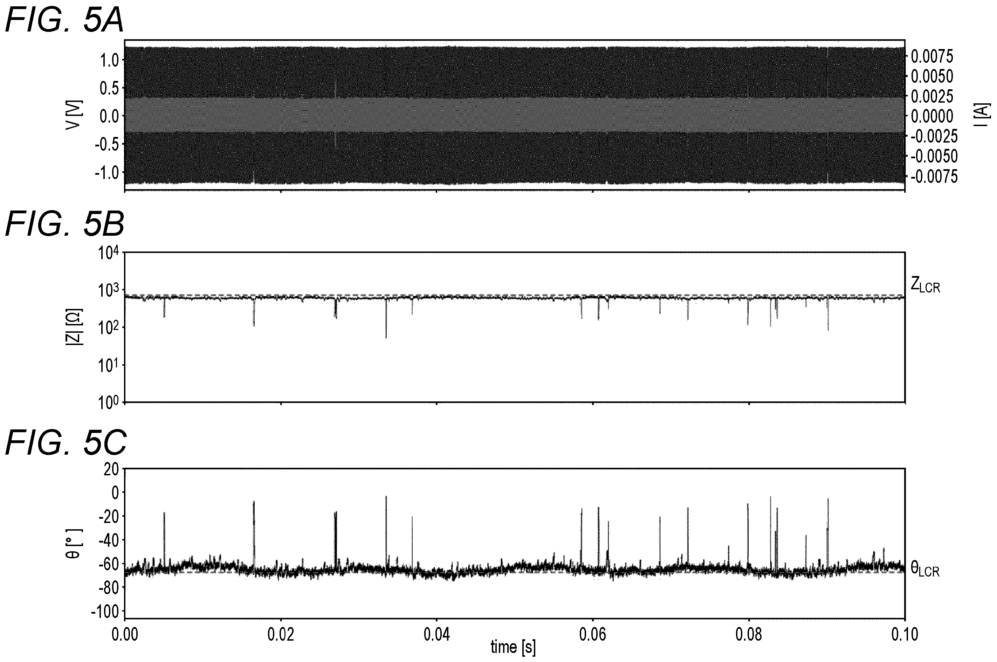

Figs. 5A to 5C are graphs illustrating an example of deriving impedance |Z| and phase $\theta$ based on waveform data detected by the oscilloscope 30. In Figs. 5A to 5C, a horizontal axis represents time [s], which corresponds to each other. Fig. 5A illustrates the waveform data detected by the oscilloscope 30, in which a left vertical axis represents voltage [V] and a right vertical axis represents current [A].

Fig. 5B illustrates impedance |Z| [Ω] calculated based on the waveform data in Fig. 5A. Fig. 5C illustrates phase $\theta$ [°] calculated based on the waveform data in Fig. 5A. In Figs. 5B and 5C, $Z_{LCR}$ and $\theta_{LCR}$ indicate results measured by the LCR meter 40.

As illustrated in Figs. 5B and 5C,, the impedance |Z| and the phase $\theta$ calculated based on the waveform data measured by the oscilloscope 30 are substantially equal to the impedance $Z_{LCR}$ and the phase $\theta_{LCR}$ measured by the LCR meter 40.

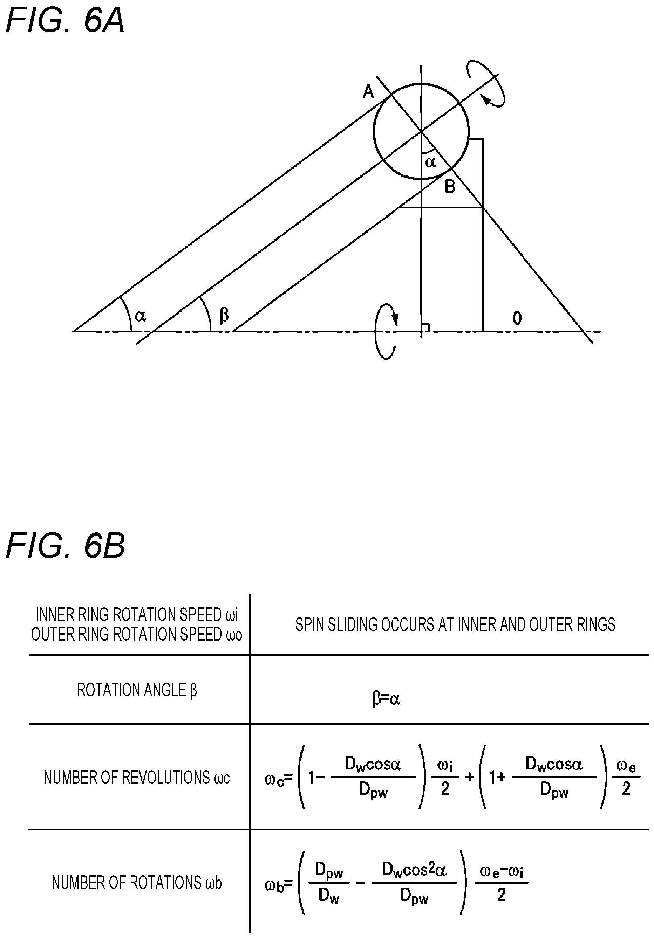

Further, in the present embodiment, the number of revolutions and the number of rotations of the rolling element 12 are calculated using values of the impedance |Z| and the phase $\theta$ as illustrated in Figs. 5B and 5C and an autocorrelation function. A theoretical value of the number of revolutions of the rolling element used for comparison is calculated using a known mathematical expression illustrated in Figs. 6A and 6B. Here, as illustrated in Fig. 6B, the calculation is performed assuming that rotation angle $\beta$ = contact angle $\alpha$ (inner and outer rings). Parameters illustrated in Fig. 6B are as follows.

$\omega_i$: inner ring rotation speed
$\omega_o$: outer ring rotation speed
$\omega_c$: number of revolutions
$\omega_b$: number of rotations
$\alpha$: contact angle of bearing
$\beta$: rotation angle
$D_{pw}$: pitch diameter of rolling element
$D_w$: diameter of rolling element

[Test Examples]

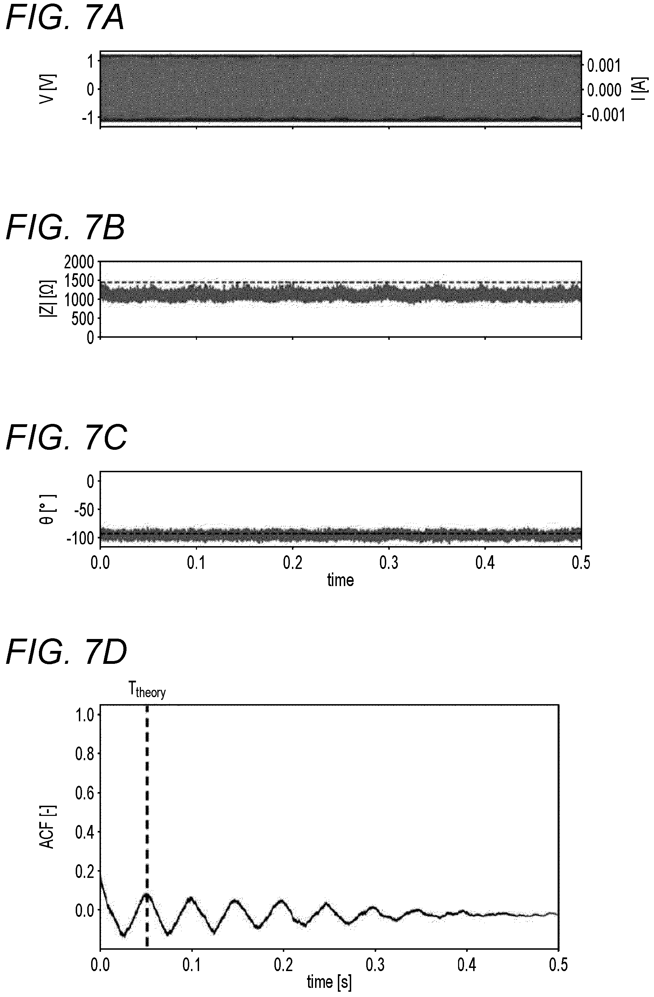

Figs. 7A to 9D illustrate test examples for verifying the measurement method according to the present embodiment. Each test uses a system configuration example illustrated in Fig. 1. First, common test conditions for each test were as follows.

(Common Conditions)

Identification number: deep groove ball bearing (6306)
Rotational speed: 400 [$min^{-1}$]
Lubricant: polyalphaolefin (PAO)-based lubricating oil
Kinematic viscosity: 128 [$mm^2/s$] (40°C)
Sine wave voltage: 0.5 [V] to 0.8 [V]
AC frequency: 1000000 [Hz]
Test conditions for differences illustrated in Figs. 7A to 9D are as follows.

(Test Condition 1)

Radial load: 100 [N]
Axial load: 0 [N]
Measurement timing: three minutes after start of rotation

(Test Condition 2)

Radial load: 100 [N]
Axial load: 0 [N]
Measurement timing: immediately after start of rotation

(Test Condition 3)

Radial load: 200 [N]
Axial load: 0 [N]
Measurement timing: three minutes after start of rotation

Fig. 7A illustrates raw waveform data of a voltage and a current measured by the oscilloscope 30 under the test condition 1. Figs. 7B and 7C illustrate impedance |Z| and phase $\theta$ calculated based on the raw waveform data illustrated in Fig. 7A. A broken line illustrated in Figs. 7B and 7C indicates values measured by the LCR meter 40. These have a similar configuration as the graph illustrated in Figs. 5A to 5C.

Fig. 7D illustrates waveform data obtained by applying the impedance |Z| and the phase $\theta$ illustrated in Figs. 7B and 7C to the autocorrelation function. In Fig. 7D, a horizontal axis represents time [s], and a vertical axis represents a value of the autocorrelation function. A broken line in Fig. 7D indicates a theoretical value $T_{theory}$ of the revolution period of the rolling element. The theoretical value $T_{theory}$ can be calculated by a formula illustrated in Figs. 6A and 6B and the following formula (4).

$$T_{theory} = 60/\text{number of revolutions of rolling element } [min^{-1}]/\text{number of rolling elements} \ldots (4)$$

As illustrated in Fig. 7D, it can be seen that the theoretical value $T_{theory}$ coincides with a value of a peak position obtained by the autocorrelation function, and the revolution period of the rolling element can be measured with high accuracy based on a value obtained by the oscilloscope 30. In other words, the revolution period of the rolling element coincides with a period of the impedance |Z|.

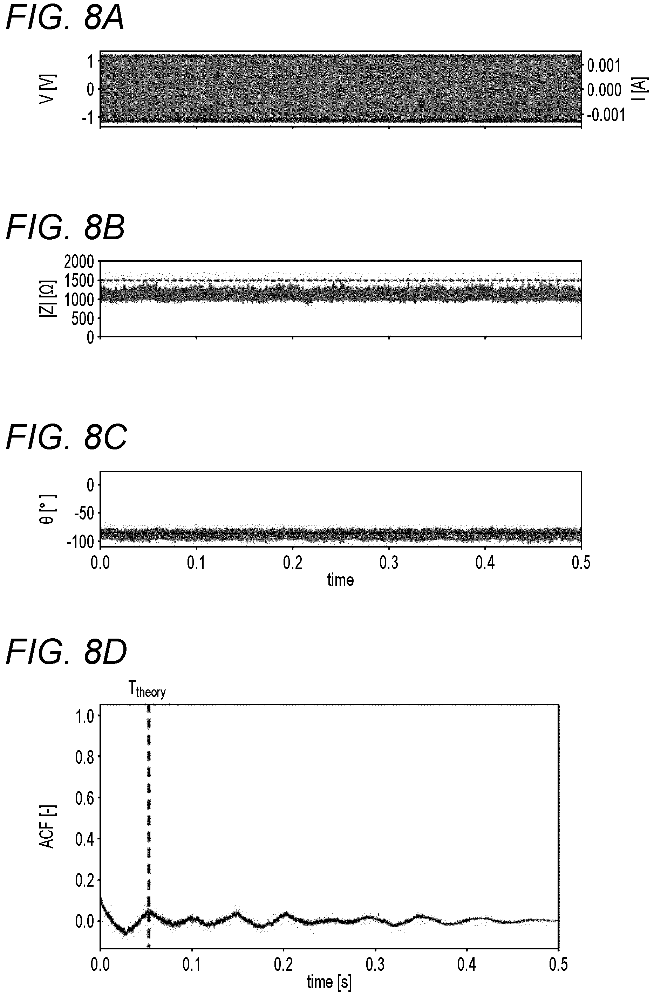

Fig. 8A illustrates raw waveform data of a voltage and a current measured by the oscilloscope 30 under the test condition 2. Figs. 8B and 8C illustrate impedance |Z| and phase $\theta$ calculated based on the raw waveform data illustrated in Fig. 8A. A broken line illustrated in Figs. 8B and 8C indicates values measured by the LCR meter 40. These have a similar configuration as the graph illustrated in Figs. 5A to 5C.

Fig. 8D illustrates waveform data obtained by applying the impedance |Z| and the phase $\theta$ illustrated in Figs. 8B and 8C to the autocorrelation function. In Fig. 8D, a horizontal axis represents time [s], and a vertical axis represents a

value of the autocorrelation function. A broken line in Fig. 8D indicates a theoretical value $T_{theory}$ of the revolution period of the rolling element.

As illustrated in Fig. 8D, a value of a peak position obtained by the autocorrelation function corresponding to the theoretical value $T_{theory}$ is slightly gentler than the value of the peak position in Fig. 7D. In other words, it can be said that the test condition 1 is more suitable for capturing the period of the impedance than the test condition 2. A difference between the test condition 1 and the test condition 2 is an acquisition timing of the waveform data. As a result, the waveform data acquired after rotation is performed for a certain period, that is, at a stable timing, can be measured with higher accuracy than immediately after the rolling bearing starts a rotation operation. In the test condition 1, the acquisition timing is set to three minutes after the start of rotation, but this is an example, and may be changed according to a configuration of the rolling bearing to be monitored.

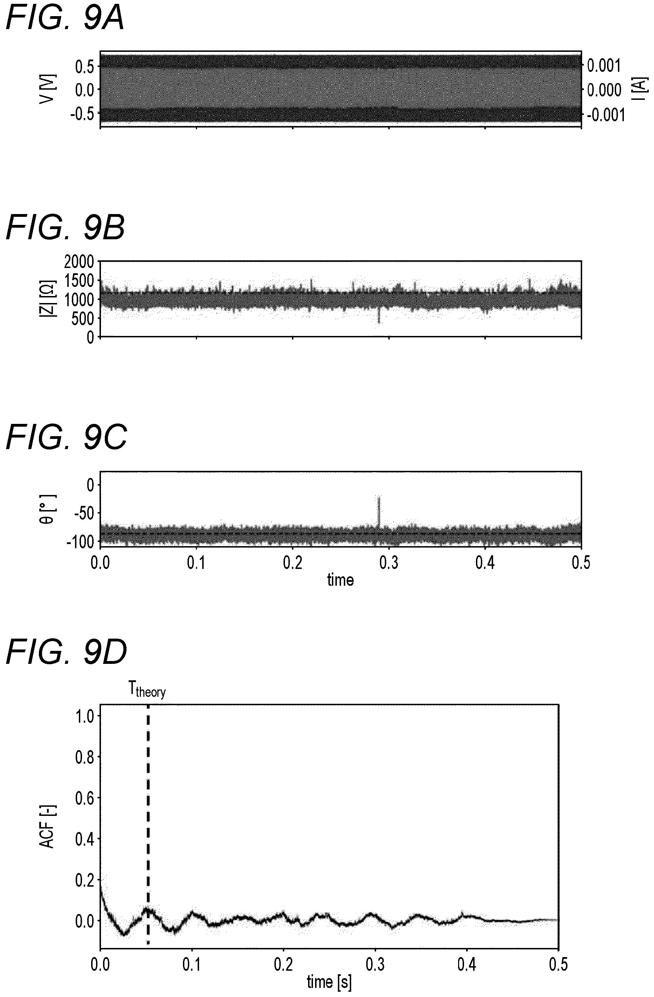

Fig. 9A illustrates raw waveform data of a voltage and a current measured by the oscilloscope 30 under the test condition 3. Figs. 9B and 9C illustrate impedance |Z| and phase θ calculated based on the raw waveform data illustrated in Fig. 9A. A broken line illustrated in Figs. 9B and 9C indicates values measured by the LCR meter 40. These have a similar configuration as the graph illustrated in Figs. 5A to 5C.

Fig. 9D illustrates waveform data obtained by applying the impedance |Z| and the phase θ illustrated in Figs. 9B and 9C to the autocorrelation function. In Fig. 9D, a horizontal axis represents time [s], and a vertical axis represents a value of the autocorrelation function. A broken line in Fig. 9D indicates a theoretical value $T_{theory}$ of the revolution period of the rolling element.

As illustrated in Fig. 9D, a value of a peak position obtained by the autocorrelation function corresponding to the theoretical value $T_{theory}$ is slightly gentler than the value of the peak position in Fig. 7D. In other words, it can be said that the test condition 1 is more suitable for capturing the period of the impedance than the test condition 3. A difference between the test condition 1 and the test condition 3 is a magnitude of a load, more specifically, a magnitude of a radial load. As a result, the waveform data acquired when the radial load on the rolling bearing is reduced can be measured with higher accuracy. In the test condition 1, the radial load is set to 100 N, but this is an example, and may change according to the configuration of the rolling bearing to be monitored.

(Correlation of Radial Load and Periodicity of Impedance)

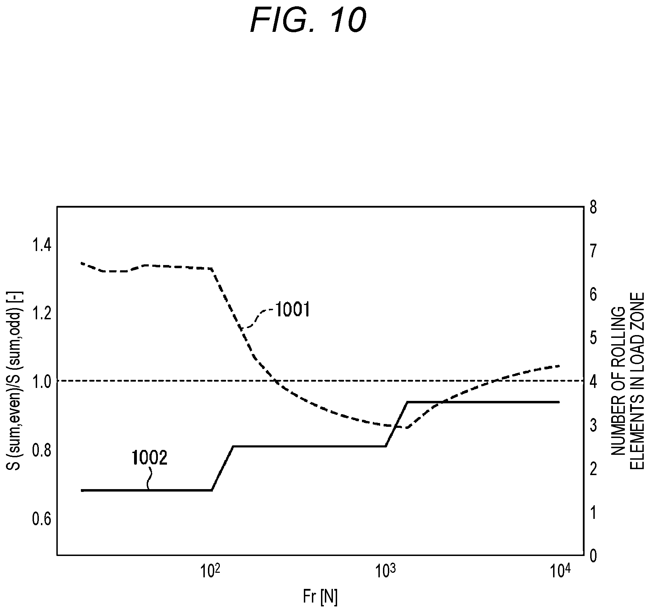

Fig. 10 is a graph illustrating a correlation among a radial load, a contact area of the rolling elements in the rolling bearing, and the number of rolling elements located in the load zone. As described with reference to Figs. 2A and 2B, the number of rolling elements in the load zone changes according to rotation of the rolling elements or a degree of load. That is, in the rotation operation, the number of rolling elements in the load zone changes while switching between an even number and an odd number. In the present example, as an index of the contact area of the rolling elements in the load zone, a ratio between even contact and odd contact as shown in the following formula (5) is used.

(contact area ratio) = (total area in even contact (average of inner and outer rings))/(total area in odd contact (average of inner and outer rings)) (5)

In Fig. 10, a horizontal axis represents a radial load Fr [N], a left vertical axis represents the contact area ratio, and the right vertical axis represents the number (average) of rolling elements in the load zone. In Fig. 10, an axial load Fa is 0. A graph 1001 illustrates a relationship between the contact area ratio and the radial load. A graph 1002 illustrates a relationship between the number of rolling elements in the load zone and the radial load. As illustrated in the graph 1002, as the radial load increases, an average number of rolling elements in the load zone increases. A value indicated by a broken line (contact area ratio = 1.0) is set for the graph 1002. Here, the contact area ratio deviates from 1 as the radial load decreases. Based on test results and the like illustrated in Figs. 7A to 9D, the present inventors have specified that periodicity of the impedance |Z| is more likely to be captured as the contact area ratio deviates from 1.0.

For example, based on the graph illustrated in Fig. 10 and the test condition 1 (radial load: 100 [N]) and the test condition 3 (radial load: 200 [N]) described above, the contact area ratio is farther from 1.0 in the test condition 1, and it can be said that the periodicity is more easily captured. In the present embodiment, based on such a correlation, a magnitude of the radial load at the time of measurement is defined such that the contact area ratio deviates from 1.0.

(Correlation Between Combined Load and Periodicity of Impedance)

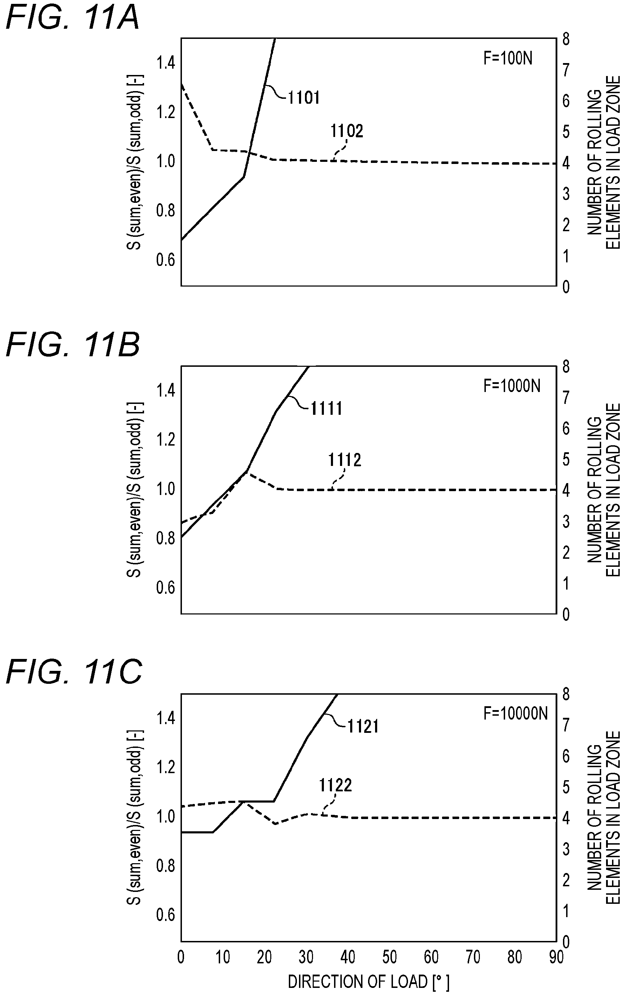

Figs. 11A to 11C are graphs illustrating a correlation among a combined load, a contact area of the rolling elements in the rolling bearing, and the number of rolling elements located in the load zone. The contact area ratio and the number of rolling elements in the load zone are similar as those described in Fig. 10.

Figs. 11A to 11C illustrate graphs when a combined load F is 100 [N], 1000 [N], and 10000 [N], respectively. In

Figs. 11A to 11C, a horizontal axis represents a direction Df of the load, Df = 0 [°] corresponds to a pure radial load (Fa = 0 [N]), and Df = 90 [°] corresponds to a pure axial load (Fr = 0 [N]).

In Figs. 11A to 11C, graphs 1101, 1111, and 1121 illustrate a relationship between the number of rolling elements in the load zone and a direction of the combined load. In each of the graphs 1101, 1111, and 1121, the number of rolling elements in the load zone increases as the direction of the combined load approaches 90°, that is, the pure axial load.

In Figs. 11A to 11C, graphs 1102, 1112, and 1122 illustrate a relationship between the contact area ratio in the load zone and the direction of the combined load. In each of the graphs 1102, 1112, and 1122, the contact area ratio tends to move away from 1.0 as the direction of the combined load approaches 0°, that is, the pure radial load. In the present embodiment, based on such a correlation, the direction of the combined load at the time of measurement is defined such that the contact area ratio deviates from 1.0. More preferably, the combined load is defined so as to be a pure radial load.

(Application Range Based on Rotational Speed)

Conditions of the rotational speed of the rolling bearing in the measurement method according to the present embodiment will be described. In the measurement method according to the present embodiment, an upper limit of the rotational speed satisfying the condition represented by the following formula (6) is set as the application range of the present method.

[Math. 2]

$$N = \frac{60f}{pn} \quad \cdots \quad (6)$$

N: number of revolutions of rolling element [$min^{-1}$]
f: sampling frequency [Hz] of impedance |Z| (< AC frequency)
p: number of samplings per period
n: number of rolling elements of rolling bearing

A range defined by the above mathematical expression is defined to be sampling at p points within a range of time 0 to time $T_{theory}$, for example, in the example in Figs. 7A to 7D. More specifically, when p = 100, N = 75000 [$min^{-1}$], and a rotation speed of the rotation ring can be applied up to 200000 [$min^{-1}$].

[Processing Flow]

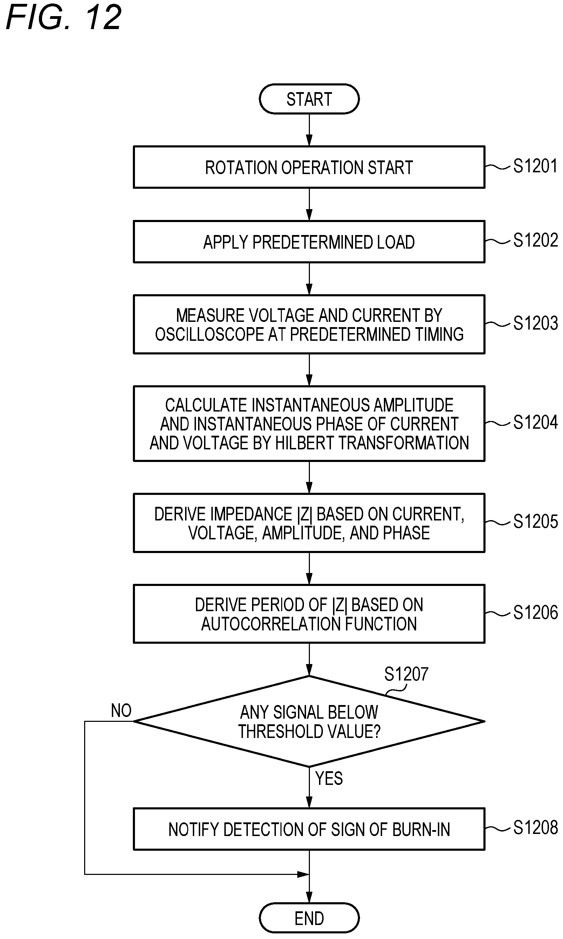

Fig. 12 is a flowchart of the state detection method for the rolling bearing according to the present embodiment. The state detection method here is performed based on a measurement method in consideration of a correlation between the period of the impedance based on the waveform data of the current and the voltage detected by the oscilloscope 30 as described above and the revolution period of the rolling element of the rolling bearing. The processing is executed by the information processing device 20, and may be implemented by, for example, the control unit 21 in the information processing device 20 reading out a program for implementing the processing according to the present embodiment from the storage unit 22 and executing the program. This processing flow may be executed at any timing based on a user instruction. As described above, in this flowchart, the measurement performed by the LCR meter 40 may be omitted.

In S1201, the information processing device 20 starts a rotation operation of the rolling bearing 10 to be detected. The rotation operation here may be started by the information processing device 20 transmitting a control signal to a motor (not illustrated), or the rotation operation of the rolling bearing 10 may be started in cooperation with another control device (not illustrated). A rotational speed of the rotation operation is within the range defined by the above formula (6).

In S1202, the information processing device 20 applies a predetermined load to the rolling bearing 10 to be detected via the rotation shaft 15. The load here may be applied by the information processing device 20 transmitting a control signal to a motor (not illustrated) or the like, or may be applied to the rolling bearing 10 in cooperation with another control device (not illustrated). In the present embodiment, a combined load of the radial load and the axial load can be applied, and is applied based on conditions illustrated in Figs. 10 and 11. For example, a predetermined radial load is applied. The start of the rotation operation in S1201 and start of load application in S1202 may be performed substantially simultaneously and integrally.

In S1203, the information processing device 20 acquires waveform data by measuring a current and a voltage applied to the rolling bearing 10 with the oscilloscope 30 at a timing when a predetermined time has elapsed from the start of the rotation operation in S1201. The predetermined timing here is defined in advance based on, for example, the conditions illustrated using Figs. 7A and 8D.

In S1204, the information processing device 20 calculates an instantaneous amplitude and instantaneous phase of the current and the voltage using Hilbert transformation for the waveform data acquired in S1203. The information processing device 20 may apply predetermined filtering processing (for example, an FIR filter) to the waveform data before applying the Hilbert transformation. In addition, thinning processing or filtering processing (for example, median filter) may be applied to data after the Hilbert transformation is applied. In this case, an interval of thinning and a size of a window of the median filter may be set to any value.

In S1205, the information processing device 20 derives impedance |Z| using a current value and a voltage value of the waveform data acquired in S1203 and the instantaneous amplitude and the instantaneous phase calculated in S1204.

In S1206, the information processing device 20 derives a period of the impedance |Z| derived in S1205 using the autocorrelation function.

In S1207, the information processing device 20 determines whether the period of the impedance |Z| derived in S1206 falls below a predetermined threshold value. The predetermined threshold value here is defined in advance in accordance with a specification of the rolling bearing 10 and is held in the storage unit 22. When the period falls below the predetermined threshold value (YES in S1207), the processing of the information processing device 20 proceeds to S1208. In this case, it means that revolution sliding occurs in the rolling bearing 10. That is, this corresponds to detection of a peak value corresponding to occurrence of the revolution sliding. Meanwhile, when the period is not below the predetermined threshold value (NO in S1207), this processing flow ends.

In S1208, the information processing device 20 determines that there is a sign of burn-in in the rolling bearing 10 that is the detection target, and notifies the fact. Then, the processing flow ends.

Although an example has been shown in which no special notification is made when the value is not below the threshold value in the processing of S1207 described above, it may be notified that no revolution sliding occurs in the rolling bearing 10 as a detection target, that is, there is no sign of burn-in.

As described above, according to the configuration of the present embodiment, for example, the revolution period of the rolling element of the rolling bearing can be measured based on the waveform data of the current and the voltage acquired by the oscilloscope. Further, based on the revolution period, a sign of burn-in in the rolling bearing can be captured and detected before an abnormality actually occurs.

<Other Embodiments>

In the present invention, a program or an application for implementing functions of the one or more embodiments described above may be supplied to a system or a device using a network or a storage medium, and processing in which one or more processors in a computer of the system or the device read and execute the program may be implemented.

In addition, the functions may be implemented by a circuit (for example, an application specific integrated circuit (ASIC) or a field programmable gate array (FPGA)) that implements one or more functions.

Thus, the present invention is not limited to the above-described embodiments, and combinations of the configurations of the embodiments and modifications and applications made by those skilled in the art based on the descriptions in the description and the well-known technique are intended by the present invention and are thus also included within the scope of the present invention to be protected.

As described above, the following matters are disclosed in the present description.

(1) A measurement device (for example, 20) for measuring a revolution period of a rolling element (for example, 12) of a rolling bearing (for example, 10) including:

an acquisition unit (for example, 23) configured to acquire waveform data of a current and a voltage applied to the rolling bearing;
a calculation unit (for example, 21) configured to calculate an instantaneous amplitude and an instantaneous phase based on the waveform data by using Hilbert transformation;
a derivation unit (for example, 21) configured to derive an impedance by using the waveform data, the instantaneous amplitude, and the instantaneous phase; and
a specification unit (for example, 21) configured to specify a period of the impedance by using an autocorrelation function and specify the period of the impedance as the revolution period of the rolling element of the rolling bearing.
According to this configuration, the revolution period of the rolling element of the rolling bearing can be measured based on the waveform data of the current and the voltage.

(2) The measurement device according to (1), in which

the acquisition unit acquires the waveform data after a predetermined time elapses since the rolling bearing starts to rotate.
According to this configuration, the revolution period of the rolling element of the rolling bearing can be measured more accurately.

(3) The measurement device according to (1) or (2), in which

the acquisition unit acquires waveform data when a predetermined radial load is applied to the rolling bearing.
According to this configuration, the revolution period of the rolling element of the rolling bearing can be measured more accurately.

(4) A state detection device (for example, 20) for a rolling bearing (for example, 10) including:

an acquisition unit (for example, 23) configured to acquire waveform data of a current and a voltage applied to the rolling bearing;
a calculation unit (for example, 21) configured to calculate an instantaneous amplitude and an instantaneous phase based on the waveform data by using Hilbert transformation;
a derivation unit (for example, 21) configured to derive an impedance by using the waveform data, the instantaneous amplitude, and the instantaneous phase;
a specification unit (for example, 21) configured to specify a period of the impedance by using an autocorrelation function and specify the period of the impedance as a revolution period of a rolling element (for example, 12) of the rolling bearing;
a detection unit (for example, 21) configured to detect revolution sliding in the rolling bearing in response to the revolution period falling below a predetermined threshold value; and
a notification unit (for example, 24) configured to output a notification of a state of the rolling bearing based on a detection result obtained by the detection unit.
According to this configuration, it is possible to accurately measure the revolution period of the rolling element of the rolling bearing based on the waveform data of the current and the voltage, capture a sign of burn-in in the rolling bearing based on the revolution period, and detect the sign before an abnormality actually occurs.

(5) A measurement method for measuring a revolution period of a rolling element (for example, 12) of a rolling bearing (for example, 10), the measurement method including:

an acquisition step (for example, S1201 to S1203) of acquiring waveform data of a current and a voltage applied to the rolling bearing;
a calculation step (for example, S1204) of calculating an instantaneous amplitude and an instantaneous phase based on the waveform data by using Hilbert transformation;
a derivation step (for example, S1205) of deriving an impedance by using the waveform data, the instantaneous amplitude, and the instantaneous phase; and
a specification step (for example, S1206) of specifying a period of the impedance by using an autocorrelation function and specifying the period of the impedance as the revolution period of the rolling element of the rolling bearing.
According to this configuration, the revolution period of the rolling element of the rolling bearing can be measured more accurately.

(6) A state detection method for a rolling bearing (for example, 10), including:

an acquisition step (for example, S1201 to S1203) of acquiring waveform data of a current and a voltage applied to the rolling bearing;
a calculation step (for example, S1204) of calculating an instantaneous amplitude and an instantaneous phase based on the waveform data by using Hilbert transformation;
a derivation step (for example, S1205) of deriving an impedance by using the waveform data, the instantaneous amplitude, and the instantaneous phase;
a specification step (for example, S1206) of specifying a period of the impedance by using an autocorrelation function and specifying the period of the impedance as a revolution period of a rolling element of the rolling bearing;
a detection step (for example, S1207) of detecting revolution sliding in the rolling bearing in response to the revolution period falling below a predetermined threshold value; and

a notification step (for example, S1208) of outputting a notification of a state of the rolling bearing based on a detection result obtained by the detection step.
According to this configuration, it is possible to accurately measure the revolution period of the rolling element of the rolling bearing based on the waveform data of the current and the voltage, capture a sign of burn-in in the rolling bearing based on the revolution period, and detect the sign before an abnormality actually occurs.

(7) A program for causing a computer (for example, 20) to execute procedures including:

an acquisition step (for example, S1201 to S1203) of acquiring waveform data of a current and a voltage applied to a rolling bearing (for example, 10);
a calculation step (for example, S1204) of calculating an instantaneous amplitude and an instantaneous phase based on the waveform data by using Hilbert transformation;
a derivation step (for example, S1205) of deriving an impedance by using the waveform data, the instantaneous amplitude, and the instantaneous phase; and
a specification step (for example, S1206) of specifying a period of the impedance by using an autocorrelation function and specifying the period of the impedance as a revolution period of a rolling element of the rolling bearing.
According to this configuration, the revolution period of the rolling element of the rolling bearing can be measured more accurately.

(8) A program for causing a computer (for example, 20) to execute procedures including:

an acquisition step (for example, S1201 to S1203) of acquiring waveform data of a current and a voltage applied to a rolling bearing (for example, 10);
a calculation step (for example, S1204) of calculating an instantaneous amplitude and an instantaneous phase based on the waveform data by using Hilbert transformation;
a derivation step (for example, S1205) of deriving an impedance by using the waveform data, the instantaneous amplitude, and the instantaneous phase;
a specification step (for example, S1206) of specifying a period of the impedance by using an autocorrelation function and specifying the period of the impedance as a revolution period of a rolling element (for example, 12) of the rolling bearing;
a detection step (for example, S1207) of detecting revolution sliding in the rolling bearing in response to the revolution period falling below a predetermined threshold value; and
a notification step (for example, S1208) of outputting a notification of a state of the rolling bearing based on a detection result obtained by the detection step.

According to this configuration, it is possible to accurately measure the revolution period of the rolling element of the rolling bearing based on the waveform data of the current and the voltage, capture a sign of burn-in in the rolling bearing based on the revolution period, and detect the sign before an abnormality actually occurs.
Although the embodiment and the variation thereof are described above with reference to the drawings, it is needless to mention that the present invention is not limited to these examples. It is apparent for those skilled in the art to which the present disclosure belongs that various modified examples or corrected examples are conceivable within the scope recited in the claims, and it is understood that the above falls within the technical scope of the present invention. In addition, the components described in the above embodiments may be combined in any manner without departing from the spirit of the invention.
The present application is based on a Japanese patent application (No. 2023-177664) filed on October 13, 2023, contents of which are incorporated herein by reference.

REFERENCE SIGNS LIST

1: measurement system
10: rolling bearing
11: outer ring
12: rolling element
13: cage
14: inner ring

15: rotation shaft
20: information processing device
21: control unit
22: storage unit
23: IF unit
24: UI unit
25: communication unit
30: oscilloscope
40: LCR meter

## Claims

**1.** A measurement device for measuring a revolution period of a rolling element of a rolling bearing, the measurement device comprising:

an acquisition unit configured to acquire waveform data of a current and a voltage applied to the rolling bearing;
a calculation unit configured to calculate an instantaneous amplitude and an instantaneous phase based on the waveform data by using Hilbert transformation;
a derivation unit configured to derive an impedance by using the waveform data, the instantaneous amplitude, and the instantaneous phase; and
a specification unit configured to specify a period of the impedance by using an autocorrelation function and specify the period of the impedance as the revolution period of the rolling element of the rolling bearing.

**2.** The measurement device according to claim 1, wherein
the acquisition unit acquires the waveform data after a predetermined time elapses since the rolling bearing starts to rotate.

**3.** The measurement device according to claim 1, wherein
the acquisition unit acquires waveform data when a predetermined radial load is applied to the rolling bearing.

**4.** A state detection device for a rolling bearing, comprising:

an acquisition unit configured to acquire waveform data of a current and a voltage applied to the rolling bearing;
a calculation unit configured to calculate an instantaneous amplitude and an instantaneous phase based on the waveform data by using Hilbert transformation;
a derivation unit configured to derive an impedance by using the waveform data, the instantaneous amplitude, and the instantaneous phase;
a specification unit configured to specify a period of the impedance by using an autocorrelation function and specify the period of the impedance as a revolution period of a rolling element of the rolling bearing;
a detection unit configured to detect revolution sliding in the rolling bearing in response to the revolution period falling below a predetermined threshold value; and
a notification unit configured to output a notification of a state of the rolling bearing based on a detection result obtained by the detection unit.

**5.** A measurement method for measuring a revolution period of a rolling element of a rolling bearing, the measurement method comprising:

an acquisition step of acquiring waveform data of a current and a voltage applied to the rolling bearing;
a calculation step of calculating an instantaneous amplitude and an instantaneous phase based on the waveform data by using Hilbert transformation;
a derivation step of deriving an impedance by using the waveform data, the instantaneous amplitude, and the instantaneous phase; and
a specification step of specifying a period of the impedance by using an autocorrelation function and specifying the period of the impedance as the revolution period of the rolling element of the rolling bearing.

**6.** A state detection method for a rolling bearing, comprising:

an acquisition step of acquiring waveform data of a current and a voltage applied to the rolling bearing;
a calculation step of calculating an instantaneous amplitude and an instantaneous phase based on the waveform data by using Hilbert transformation;
a derivation step of deriving an impedance by using the waveform data, the instantaneous amplitude, and the instantaneous phase;
a specification step of specifying a period of the impedance by using an autocorrelation function and specifying the period of the impedance as a revolution period of a rolling element of the rolling bearing;
a detection step of detecting revolution sliding in the rolling bearing in response to the revolution period falling below a predetermined threshold value; and
a notification step of outputting a notification of a state of the rolling bearing based on a detection result obtained by the detection step.

**7.** A program for causing a computer to execute procedures comprising:

an acquisition step of acquiring waveform data of a current and a voltage applied to a rolling bearing;
a calculation step of calculating an instantaneous amplitude and an instantaneous phase based on the waveform data by using Hilbert transformation;
a derivation step of deriving an impedance by using the waveform data, the instantaneous amplitude, and the instantaneous phase; and
a specification step of specifying a period of the impedance by using an autocorrelation function and specifying the period of the impedance as a revolution period of a rolling element of the rolling bearing.

**8.** A program for causing a computer to execute procedures comprising:

an acquisition step of acquiring waveform data of a current and a voltage applied to a rolling bearing;
a calculation step of calculating an instantaneous amplitude and an instantaneous phase based on the waveform data by using Hilbert transformation;
a derivation step of deriving an impedance by using the waveform data, the instantaneous amplitude, and the instantaneous phase;
a specification step of specifying a period of the impedance by using an autocorrelation function and specifying the period of the impedance as a revolution period of a rolling element of the rolling bearing;
a detection step of detecting revolution sliding in the rolling bearing in response to the revolution period falling below a predetermined threshold value; and
a notification step of outputting a notification of a state of the rolling bearing based on a detection result obtained by the detection step.

FIG. 1

1
20
INFORMATION PROCESSING DEVICE
21
CONTROL UNIT
22
STORAGE UNIT
23
IF UNIT
24
UI UNIT
25
COMMUNICATION UNIT
30
OSCILLOSCOPE
40
LCR meter
10
RADIAL LOAD
AXIAL LOAD
15

FIG. 2A

FIG. 2B

FIG. 3A

FIG. 3B

301
303
302
1.0
0.5
0.0
-0.5
-1.0
V [V]
0.0075
0.0050
0.0025
0.0000
-0.0025
-0.0050
-0.0075
I [A]
0.00
0.02
0.04
0.06
0.08
0.10
time [s]
302
303
0.03339
0.03340
0.03341
0.03342
0.03343
0.03344
0.03345
0.03346
0.03347
time [s]

FIG. 4A

401
402
1.0
0.5
V [V]
0.0
-0.5
-1.0
0.0075
0.0050
0.0025
0.0000
-0.0025
-0.0050
-0.0075
I [A]

FIG. 4B

411
412
1.2
1.0
0.8
0.6
0.4
0.2
V_abs [V]
0.008
0.007
0.006
0.005
0.004
0.003
0.002
I_abs [A]

FIG. 4C

421
422
PHASE DIFFERENCE θ
150
100
50
0
-50
-100
-150
Phase [°]
0.03339
0.03340
0.03341
0.03342
0.03343
0.03344
0.03345
0.03346
0.03347
time [s]

FIG. 5A
V [V]
1.0
0.5
0.0
-0.5
-1.0
I [A]
0.0075
0.0050
0.0025
0.0000
-0.0025
-0.0050
-0.0075
FIG. 5B
|Z| [Ω]
$10^4$
$10^3$
$10^2$
$10^1$
$10^0$
$Z_{LCR}$
FIG. 5C
θ [°]
20
0
-20
-40
-60
-80
-100
$\theta_{LCR}$
0.00
0.02
0.04
0.06
0.08
0.10
time [s]

# FIG. 6A

A
α
B
α
β
0

# FIG. 6B

| INNER RING ROTATION SPEED ωi<br>OUTER RING ROTATION SPEED ωo | SPIN SLIDING OCCURS AT INNER AND OUTER RINGS |
|---|---|
| ROTATION ANGLE β | $\beta=\alpha$ |
| NUMBER OF REVOLUTIONS ωc | $\omega_c=\left(1-\frac{D_w\cos\alpha}{D_{pw}}\right)\frac{\omega_i}{2}+\left(1+\frac{D_w\cos\alpha}{D_{pw}}\right)\frac{\omega_e}{2}$ |
| NUMBER OF ROTATIONS ωb | $\omega_b=\left(\frac{D_{pw}}{D_w}-\frac{D_w\cos^2\alpha}{D_{pw}}\right)\frac{\omega_e-\omega_i}{2}$ |

FIG. 7A

V [V]
1
0
-1
0.001
0.000
-0.001
I [A]

FIG. 7B

|Z| [Ω]
2000
1500
1000
500
0

FIG. 7C

θ [°]
0
-50
-100
0.0
0.1
0.2
0.3
0.4
0.5
time

FIG. 7D

T theory
ACF [-]
1.0
0.8
0.6
0.4
0.2
0.0
0.0
0.1
0.2
0.3
0.4
0.5
time [s]

# FIG. 8A

V [V]
1
0
-1
0.001
0.000
-0.001
I [A]

# FIG. 8B

|Z| [Ω]
2000
1500
1000
500
0

# FIG. 8C

θ [°]
0
-50
-100
0.0
0.1
0.2
0.3
0.4
0.5
time

# FIG. 8D

T theory
ACF [-]
1.0
0.8
0.6
0.4
0.2
0.0
0.0
0.1
0.2
0.3
0.4
0.5
time [s]

FIG. 9A

V [V]
0.5
0.0
-0.5
0.001
0.000
-0.001
I [A]

FIG. 9B

|Z| [Ω]
2000
1500
1000
500
0

FIG. 9C

θ [°]
0
-50
-100
0.0
0.1
0.2
0.3
0.4
0.5
time

FIG. 9D

T theory
ACF [-]
1.0
0.8
0.6
0.4
0.2
0.0
0.0
0.1
0.2
0.3
0.4
0.5
time [s]

# FIG. 10

S (sum,even)/S (sum,odd) [-]
1.4
1.2
1.0
0.8
0.6
8
7
6
5
4
3
2
1
0
NUMBER OF ROLLING
ELEMENTS IN LOAD ZONE
1001
1002
$10^2$
$10^3$
$10^4$
Fr [N]

FIG. 11A
F=100N
1101
1102
S (sum,even)/S (sum,odd) [-]
NUMBER OF ROLLING ELEMENTS IN LOAD ZONE
1.4
1.2
1.0
0.8
0.6
8
7
6
5
4
3
2
1
0
FIG. 11B
F=1000N
1111
1112
S (sum,even)/S (sum,odd) [-]
NUMBER OF ROLLING ELEMENTS IN LOAD ZONE
FIG. 11C
F=10000N
1121
1122
S (sum,even)/S (sum,odd) [-]
NUMBER OF ROLLING ELEMENTS IN LOAD ZONE
0
10
20
30
40
50
60
70
80
90
DIRECTION OF LOAD [° ]

FIG. 12

START
ROTATION OPERATION START
S1201
APPLY PREDETERMINED LOAD
S1202
MEASURE VOLTAGE AND CURRENT BY OSCILLOSCOPE AT PREDETERMINED TIMING
S1203
CALCULATE INSTANTANEOUS AMPLITUDE AND INSTANTANEOUS PHASE OF CURRENT AND VOLTAGE BY HILBERT TRANSFORMATION
S1204
DERIVE IMPEDANCE |Z| BASED ON CURRENT, VOLTAGE, AMPLITUDE, AND PHASE
S1205
DERIVE PERIOD OF |Z| BASED ON AUTOCORRELATION FUNCTION
S1206
S1207
ANY SIGNAL BELOW THRESHOLD VALUE?
NO
YES
NOTIFY DETECTION OF SIGN OF BURN-IN
S1208
END

## INTERNATIONAL SEARCH REPORT

International application No.
**PCT/JP2024/036484**

**A. CLASSIFICATION OF SUBJECT MATTER**

***G01M 13/04***(2019.01)i; ***G01R 31/00***(2006.01)i
FI: G01M13/04; G01R31/00

According to International Patent Classification (IPC) or to both national classification and IPC

**B. FIELDS SEARCHED**

Minimum documentation searched (classification system followed by classification symbols)

G01M13/04; G01R31/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2022/054352 A1 (NSK LTD.) 17 March 2022 (2022-03-17) paragraphs [0043]-[0055] | 1-8 |
| A | JP 2021-032797 A (NSK LTD.) 01 March 2021 (2021-03-01) paragraphs [0026]-[0051] | 1-8 |
| A | JP 2010-181334 A (OKUMA CORPORATION) 19 August 2010 (2010-08-19) paragraph [0030] | 1-8 |

☐ Further documents are listed in the continuation of Box C.   ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 November 2024** | **26 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/036484**

| Patent document cited in search report | Publication date (day/month/year) | Patent family member(s) | Publication date (day/month/year) |
|---|---|---|---|
| WO 2022/054352 A1 | 17 March 2022 | US 2023/0366781 A1<br>paragraphs [0103]-[0131]<br>EP 4212749 A1<br>CN 116113772 A<br>BR 112023004613 A2<br>KR 10-2023-0048419 A | |
| JP 2021-032797 A | 01 March 2021 | (Family: none) | |
| JP 2010-181334 A | 19 August 2010 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021032769 A
- JP 7027782 B
- JP 2006017291 A
- JP 2023177664 A